(19) **Europäisches Patentamt**

**European Patent Office**

**Office européen des brevets**

(11) Veröffentlichungsnummer: **0 378 628 B1**

(12) # EUROPÄISCHE PATENTSCHRIFT

(45) Veröffentlichungstag der Patentschrift: **22.09.93**

(21) Anmeldenummer: **89907094.0**

(22) Anmeldetag: **05.07.89**

(86) Internationale Anmeldenummer:
**PCT/DE89/00441**

(87) Internationale Veröffentlichungsnummer:
**WO 90/00743 (25.01.90 90/03)**

(51) Int. Cl.⁵: **G01R 33/46**, G01R 33/54

(54) **VERFAHREN ZUR ERZEUGUNG EINER FOLGE VON SPINECHOSIGNALEN, DIE VERWENDUNG DIESES VERFAHRENS BEI DER KERNSPINTOMOGRAPHIE UND VORRICHTUNG ZUM DURCHFÜHREN BZW. ZUR VERWENDUNG DIESES VERFAHRENS.**

(30) Priorität: **09.07.88 DE 3823398**

(43) Veröffentlichungstag der Anmeldung:
**25.07.90 Patentblatt 90/30**

(45) Bekanntmachung des Hinweises auf die
Patenterteilung:
**22.09.93 Patentblatt 93/38**

(84) Benannte Vertragsstaaten:
**CH DE FR GB LI**

(73) Patentinhaber: **Spectrospin AG**
**Industriestrasse 26**
**CH-8117 Zürich-Fällanden(CH)**

(72) Erfinder: **HENNIG, Jürgen**
**Johann-von-Weerth-Str. 12**
**D-7800 Freiburg(DE)**

(74) Vertreter: **KOHLER SCHMID + PARTNER Patentanwälte**
**Ruppmannstrasse 27**
**D-70565 Stuttgart (DE)**

EP 0 378 628 B1

**Beschreibung**

Die Erfindung betrifft ein Verfahren zur Erzeugung einer Folge von Spinechosignalen bei der NMR-Spektroskopie, bei dem eine in einem homogenen Magnetfeld angeordnete Probe mit einer Folge von HF-Impulsen angeregt wird, die die Erzeugung von Spinechosignalen zur Folge haben, wobei die Probe gleichzeitig einem magnetischen Gradientenfeld ausgesetzt und zur Anregung der Probe eine Folge von äquidistanten HF-Impulsen mit Flip-Winkeln $\alpha < 180\,°$ verwendet wird.

Beispielsweise aus der DE-OS 35 18 950 und der EP-OS 0 238 139 sind derartige Verfahren zur Erzeugung von Spinechosignalen bekannt. Allen diesen Verfahren ist gemeinsam, daß Maßnahmen getroffen werden, um den durch die Dephasierung der angeregten Spins infolge von Inhomogenitäten des Magnetfeldes auftretenden Induktionszerfall rückgängig zu machen, so daß eine ein neues Signal ergebende Rephasierung eintritt. Zur erwähnen ist beispielsweise die Carr-Purcell-Impulsfolge, bei der einem $90\,°$-Anregungsimpuls eine Anzahl von $180\,°$-Impulsen folgt, welche eine Rephasierung bewirken, so daß nach jedem $180\,°$-Impuls ein Spinechosignal auftritt. Durch Aufaddieren der Spinechosignale kann eine bedeutende Verbesserung des Signal/Rausch-Verhältnisses erzielt werden. Ein ähnlicher Effekt läßt sich auch durch das Einschalten von Gradientenfeldern zwischen den Spinechosignalen erzielen. Es ist auch bekannt, solche Verfahren zur Erzeugung einer Folge von Spinechosignalen bei der Kernspintomographie anzuwenden und die einzelnen Spinechosignale unterschiedlich zu codieren, so daß im Extremfall schon eine Folge von Spinechosignalen ausreicht, um die für die Erzeugung eines zweidimensionalen Bildes erforderlichen Signale zu erhalten.

Der Nachteil der bekannten Verfahren zur Erzeugung einer Folge von Spinechosignalen besteht darin, daß sie noch immer eine erhebliche Zeit beanspruchen, weil zwischen dem Auftreten der einzelnen Spinechosignale die zur Refokussierung benötigten Gradientenschaltvorgänge liegen, welche eine endliche Zeit beanspruchen. Obwohl es technisch möglich wäre, Gradienten so schnell zu schalten, daß nach dem aus der DE-OS 34 34 161 bekannten Verfahren eine Bildaufnahme in einigen Millisekunden erfolgen könnte, sind solche Meßsequenzen nur zur Gewinnung einer Folge von wenigen Bildern geeignet, da solche Sequenzen inhärent eine extreme mechanische Beanspruchung des Meßsystems sowie - dadurch bedingt - eine extreme Lärmbelästigung des Patienten nach sich ziehen würden. Beim Schalten von Gradienten mit derart hohen Geschwindigkeiten würden zudem die für die Patientenuntersuchungen zulässigen Grenzwerte weit überschritten.

Eine kontinuierliche Erzeugung von Schnittbildern - wie etwa beim Ultraschallverfahren - ist daher mit diesen Techniken nicht möglich.

Daher liegt der Erfindung die Aufgabe zugrunde, ein Verfahren zur Erzeugung einer Folge von Spinechosignalen bei der NMR-Spektroskopie anzugeben, deren Spinechosignale in sehr kurzen Zeitabständen auftreten, so daß die Beobachtung schneller Vorgänge möglich ist, zumal die Möglichkeit besteht, die einzelnen Spinechosignale auf einfache Weise mit einem zu beobachtenden Parameter zu codieren.

Diese Aufgabe wird nach der Erfindung dadurch gelöst, daß die HF-Impulse unterschiedliche Amplituden aufweisen und die Flipwinkel $\alpha$ und die Amplituden der HF-Impulse derart gewählt sind, daß das Produkt aus der Anzahl der HF-Impulse und dem Flipwinkel der einzelnen Impulse einen Gesamt-Flipwinkel zwischen $90\,°$ und $180\,°$ ergibt und im Anschluß an die Folge der HF-Impulse ein Zug von äquidistanten Echosignalen mit möglichst konstanter Amplitude erhalten wird.

Die Erfindung macht demnach von der bekannten Erscheinung Gebrauch, daß eine Folge von dicht aufeinanderfolgenden HF-Impulsen auch eine Folge von dicht aufeinanderfolgenden Echosignalen erzeugt, wie es beispielsweise von Kaiser et al. in J. Chem. Phys. 60, 2966 (1974) beschrieben ist. Es wurden jedoch bisher nur wenige Echosignale mit stark abnehmender Amplitude beobachtet, die in den aufgenommenen Spektren als Störsignale auftraten, und es wurde demgemäß nach Mitteln gesucht, um diese Echosignale zu vermeiden. Eine Möglichkeit, diese Echosignale als Nutzsignale zu verwerten, wurde bisher nicht gesehen. Eine solche Möglichkeit wird erst durch die Erfindung eröffnet, nach der durch Anlegen eines magnetischen Gradientenfeldes und die Anwendung von HF-Impulsen unterschiedlicher Amplitude dafür Sorge getragen wird, daß eine große Anzahl von Spinechosignalen mit möglichst konstanter Amplitude erscheint, die eine nutzbare Auswertung ermöglichen. Dabei ist insbesondere bei der Verwendung des Verfahrens bei der Bilderzeugung ein Absinken der Amplitude der Echosignale auf ein Viertel der Anfangsamplitude noch nicht sehr störend, und soll noch die Bedingung erfüllen, daß die Echosignale eine möglichst konstante Amplitude aufweisen. Da die unvermeidliche Abnahme der Amplitude der Echosignale eine Funktion der Amplitudenvariation der HF-Impulse und demgemäß bekannt ist, besteht auch die Möglichkeit, durch entsprechende Steuerung des Verstärkungsfaktors des Empfängers oder auch rechnerisch für einen Amplitudenausgleich zu sorgen.

2

Ein besonderer Vorteil des erfindungsgemäßen Verfanrens besteht darin, daß das magnetische Gradientenfeld dazu benutzt werden kann, einen interessierenden Parameter zu codieren, insbesondere die Dichteverteilung der angeregten Spins in Richtung des Gradienten. Dabei kann der Gradient während der ganzen Dauer des von der Folge der HF-Impulse gebildeten Puls-Burst und der sich anschließenden Folge von Echosignalen konstant sein. Es besteht aber auch die Möglichkeit, die Größe des magnetischen Gradientenfeldes in den Zeitintervall zwischen der Folge der HF-Impulse und dem Beginn der Folge der Echosignale zu ändern. Durch eine Erhöhung des magnetischen Gradienten wird der zeitliche Abstand zwischen den Echosignalen gegenüber dem zeitlichen Abstand zwischen den HF-Impulsen vermindert und dadurch die Auslesezeit reduziert. Eine Verminderung des magnetischen Gradientenfeldes zieht zwar dementsprechend eine Vergrößerung des zeitlichen Abstandes zwischen den Echosignalen und demgemäß eine Verlängerung der Gesamtmeßzeit nach sich, führt aber zu einer Verbesserung des Signal/Rausch-Verhältnisses wegen der geringeren Bandbreite der Datenaufnahme. Je nach der Art der Verwendung des erfindungsgemäßen Verfahrens kann daher die eine oder die andere Variante von praktischem Interesse sein.

Die Folge der HF-Impulse braucht nicht lückenlos zu sein, sondern es kann vielmehr eine Folge äquidistanter HF-Impulse erzeugt werden, die an vorgegebenen Stellen Lücken aufweist, ohne daß auch entsprechende Lücken in der Folge der Echosignale entstehen. Hierdurch läßt sich die mittels der Folge der HF-Impulse auf die Probe eingestrahlte Gesamtenergie vermindern, was in manchen Fällen vorteilhaft sein kann. Allerdings wird entsprechend auch die Gesamtenergie der Echosignale geringer, so daß durch die Anforderungen an die Amplitude der Echosignale einer Ausdünnung der Folge der HF-Impulse Grenzen gesetzt sind. Im übrigen erfordert eine Lücken aufweisende Folge von HF-Impulsen eine andere Variation der Amplitude der HF-Impulse als eine lückenlose Folge.

Es hat sich gezeigt, daß außer der Amplitude auch die Phase des Trägersignals der HF-Impulse für die Amplitude der Echosignale von Bedeutung ist. Daher sieht eine weitere Ausgestaltung der Erfindung vor, daß die HF-Impulse zusätzlich phasenmoduliert werden. So führt beispielsweise eine Folge, bei der die Phase einer Hälfte der HF-Impulse gegenüber der Phase der zweiten Hälfte der HF-Impulse um 90° phasenverschoben ist, zu einer Verlängerung der Folge der Echosignale.

Wie bereits erwähnt, können auch die nach dem erfindungsgemäßen Verfahren erzeugten Echosignale für die Bilderzeugung in der NMR-Tomographie Anwendung finden. Dabei wird durch das magnetische Gradientenfeld eine Codierung in der Gradientenrichtung erzielt, und es entspricht das magnetische Gradientenfeld dem sonst bei der NMR-Tomographie üblicherweise angewendeten Lesegradienten. Demgemäß ist Gegenstand der Erfindung auch die Verwendung des vorstehend behandelten Verfahrens bei der Bilderzeugung. Dabei können die für die Punkte eines zweidimensionalen Bildes charakteristischen Signale in besonders vorteilhafter Weise dadurch gewonnen werden, daß nach Abschluß der Folge von HF-Impulsen und für die Dauer der Folge der Echosignale die Probe zusätzlich einem zum magnetischen Gradientenfeld senkrechten magnetischen Phasengradienten ausgesetzt wird und die erhaltenen Echosignale einer zweidimensionalen Fouriertransformation unterworfen werden, welche die für die Punkte des Bildes charakteristischen Signale ergibt.

Durch die Verwendung des erfindungsgemäßen Verfahrens zur Erzeugung der für die Punkte eines zweidimensionalen Bildes charakteristischen Signale ist es möglich, bei der Kernspintomographie Bilder in einer sehr kurzen Zeit zu erzeugen. Darüberhinaus bleibt wegen der Anwendung von HF-Impulsen mit sehr kleinem Flipwinkel ein sehr großer Teil der Magnetisierung der Probe im Bereich des thermischen Gleichgewichtes, so daß die Sequenzen auch sehr schnell wiederholt werden können. Damit eröffnet das erfindungsgemäße Verfahren erstmals die Möglichkeit, Bilder in sehr dichter Folge zu erzeugen, die eine filmartige Darstellung und damit die Beobachtung von Bewegungsvorgängen in der Probe ermöglichen. Da außerdem weder der Lesegradient noch der Phasengradient während der Folge der Echosignale geschaltet werden muß und weiterhin die bei einer Meßsequenz eingestrahlte HF-Energie gering bleibt, sind alle Voraussetzungen erfüllt, um derartige Aufnahmen auch am menschlichen Körper auszuführen und dabei die Funktion von Körperorganen zu beobachten. Damit ergeben sich Möglichkeiten für eine Echtzeit-Überwachung, wie sie bisher nur mit Ultraschallgeräten möglich war.

Wie bereits erwähnt, kann der Phasengradient während der Dauer der Folge der Echosignale konstant sein, weil bei konstantem Phasengradienten eine monoton zunehmende Dephasierung der Echosignale eintritt. Hieraus ergeben sich zwar auch gewisse Abbildungsfehler, die jedoch bei Verwendung einer hinreichend großen Datenmatrix unerheblich sind. Der Vorteil besteht darin, daß der Phasengradient während der Aufnahmezeit nicht geschaltet zu werden braucht, das Einschalten in dem Intervall zwischen dem Ende der Folge der HF-Impulse und dem Beginn der Folge der Echosignale relativ langsam erfolgen kann und wegen der akkumulierenden Wirkung des Phasengradienten seine Stärke auch klein sein kann. Daher tritt durch das Einschalten des Phasengradienten für einen mittels Kernspin-Tomographie untersuchten Patienten keine Belastung auf.

Es besteht aber auch die Möglichkeit, die durch einen konstanten Phasengradienten auftretenden Bildfehler dadurch zu vermeiden, daß der Phasengradient jeweils in den Intervallen zwischen den einzelnen Echosignalen impulsartig eingeschaltet wird. Hierdurch wird eine direkte Datensammlung in einem orthogonalen Raster ermöglicht. Da auch hier der Phasencodiergradient sehr schwach sein kann, bereitet das schnelle Schalten des Phasengradienten zwischen den Echosignalen keine Schwierigkeiten und führt auch nicht zu starken Belastungen eines Patienten.

Im übrigen können auch bei der Verwendung des erfindungsgemäßen Verfahrens zur Erzeugung von Bildern bei der Kernspintomographie die sonst aus der Kernspintomographie bekannten Verfahren zur Scheibenselektion Anwendung finden, und es besteht auch die Möglichkeit, das zweidimensionale Verfahren zu einem dreidimensionalen Verfahren zu erweitern. So kann beispielsweise vor dem Einstrahlen der Folge der HF-Impulse die Probe einem Scheibenselektionsgradienten und einem selektiven Anregungsimpuls ausgesetzt werden, nach dem dann die Folge der HF-Impulse die Wirkung eines Refokussierimulses hat. Stattdessen könnte auch die Probe vor dem Einstrahlen der Folge der HF-Impulse einem Scheibenselektionsgradienten und einem HF-Impuls ausgesetzt werden, durch den die außerhalb der selektierten Scheibe liegenden Bereiche der Probe gesättigt werden, so daß auf das erfindungsgemäße Verfahren nur noch die sich innerhalb der ungestörten Scheibe befindenden Spins ansprechen. Eine weitere Möglichkeit besteht darin, daß nach Beendigung der Folge von HF-Impulsen und vor Beginn der Folge von Echoimpulsen auf die Probe ein scheibenselektiver Refokussierimpuls eingestrahlt und für die Dauer des Refokussierimpulses das magnetische Gradientenfeld durch einen Selektionsgradienten ersetzt wird.

Zur Erfassung der dritten Dimension können in analoger Weise die Methoden der dreidimensionalen Fouriertransformation angewendet oder aber die zur Erzeugung der für die Punkte eines zweidimensionalen Bildes charakteristischen Signale dienenden Maßnahmen nacheinander für eine gewünschte Anzahl dicht nebeneinander liegender Scheiben wiederholt werden.

Gegenstand der Erfindung ist endlich auch eine Vorrichtung zum Durchführen des erfindungsgemäßen Verfahrens bzw. seiner Verwendung zur Bilderzeugung. Ebenso wie die bekannten Vorrichtungen weist auch die erfindungsgemäße Vorrichtung einen zur Erzeugung von HF-Impulsen ausgebildeten Sender auf, jedoch muß erfindungsgemäß der Sender zur Erzeugung von Folgen sehr dicht aufeinanderfolgender, äquidistanter HF-Impulse mit von Impuls zu Impuls veränderlicher Amplitude und gegebenenfalls auch Phase eingerichtet sein.

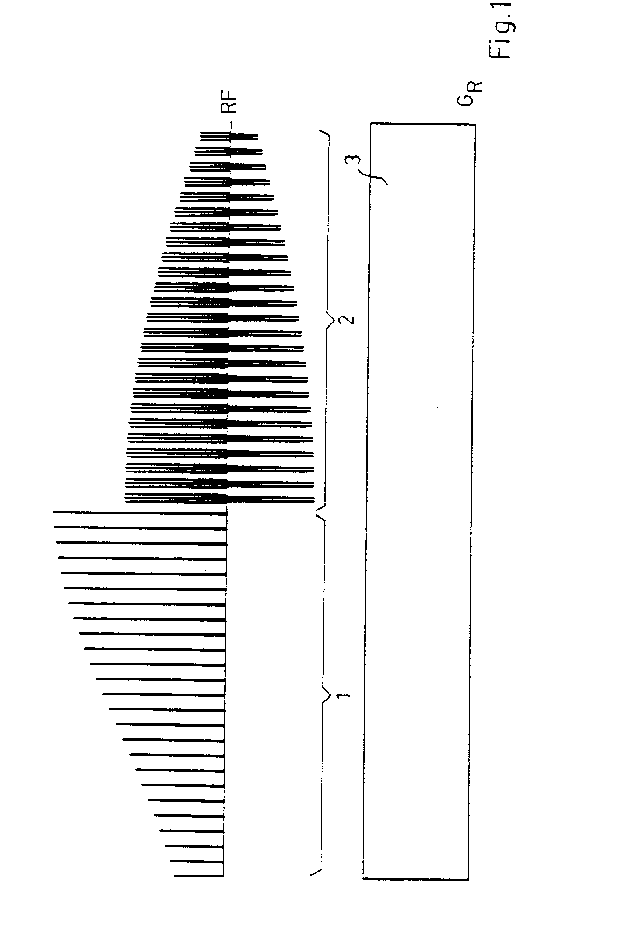

Die Erfindung wird im Folgenden anhand der in den Fig. 1 bis 7 dargestellten Diagramme näher beschrieben und erläutert. Die der Beschreibung in Verbindung mit den Diagrammen zu entnehmenden Merkmale können bei der Vielzahl der möglichen Varianten des erfindungsgemäßen Verfahrens und dessen Verwendung einzeln für sich oder in beliebiger Kombination Anwendung finden.

Fig. 1 veranschaulicht die Basissequenz des erfindungsgemäßen Verfahrens. Wie aus Fig. 1 ersichtlich, ist die Amplitude der HF-Impulse in der Weise moduliert, daß diese Amplitude im Verlauf des Puls-Burst zunimmt. Hierdurch wird erreicht, daß eine große Zahl von Echosignalen mit nur langsam abnehmender Amplitude erhalten wird. Die Variation der Amplitude der HF-Impulse läßt sich nach den von D.E. Woessner in J. Chem. Phys. 34, 2057 (1961) angegebenen Gleichungen (9) und (10) berechnen.

$$F(t + t_w) = F(t)\cos^2\tfrac{1}{2}\,\vartheta + F^*(t)\sin^2\tfrac{1}{2}\,\vartheta - iM_z(t)\sin\vartheta$$

und

$$M_z(t + t_w) = M_z(t)\cos\vartheta - \tfrac{1}{2}\,i[F(t) - F^*(t)]\sin\vartheta \ ,$$

wobei

$$\vartheta = \omega t_w \ ; \ \omega = \gamma H_1 \, .$$

Dabei bezeichnet $\gamma$ das kern-gyromagnetische Verhältnis, $H_1$ die Größe der effektiv rotierenden Komponente des HF-Feldes, $t_w$ die zeitliche Dauer des angelegten HF-Feldes, F die rotierende Komponente der Kernmagnetisierung und $M_z$ die longitudinale Magnetisierung.

Obwohl die Erzeugung einer Folge von Echosignalen mit gleicher Amplitude nur für einen gegen 0° gehenden Anregungs-Flipwinkel erzeugbar ist, der zu untauglich kleinen Signalamplituden führen würde, läßt sich ein guter Kompromiß zwischen ausreichend großer Amplitude und ausreichender Amplitudenkonstanz auch für eine zur Messung tauglichen Signalstärke erreichen.

Die Anregungssequenz 1 besteht aus einer Folge von vielen HF-Impulsen, die auch als Puls-Burst bezeichnet wird. Es handelt sich vorzugsweise um 64, 128 oder 256 HF-Impulse mit rechteckigem Anregungsprofil und einer typischen Dauer von 1 bis 20 $\mu$s. Sie haben unterschiedliche Amplituden und einen typischen Flipwinkel von 0,1° bis 2°. Sie folgen in einem zeitlich konstanten Abstand aufeinander. Der typische Abstand zwischen den HF-Impulsen beträgt 50 bis 1000 $\mu$s. Nach Beendigung des Puls-Burst 1 bildet sich die dargestellte Folge von Echosignalen. Die Sequenz von Puls-Burst 1 und Echosignalen 2 findet unter einem zeitlich konstanten magnetischen Gradientenfeld 3 statt, das auch als Lesegradient $G_R$ bezeichnet werden kann.

Es sei erwähnt, daß in dem in Fig. 1 dargestellten Puls-Burst die HF-Impulse nicht lückenlos vorzuliegen brauchen. Unter "äquidistanter Impulsfolge" ist in diesem Zusammenhang eine Impulsfolge zu verstehen, bei der die einzelnen Impulse gleiche zeitliche Abstände, aber eventuell sehr unterschiedliche Amplituden haben; insbesondere kann die Amplitude Null auftreten, d.h. ein Impuls in der Impulsfolge ausfallen. In der oben erwähnten Literaturstelle ist beschrieben, daß bereits wenige HF-Impulse die Erzeugung sehr vieler Echos zur Folge haben können. Daher kann in der den Puls-Burst 1 bildenden Folge von prinzipiell äquidistanten HF-Impulsen eine mehr oder minder große Anzahl von HF-Impulsen ausgelassen werden. Eine Minimalisierung der Anzahl der HF-Impulse kann erreicht werden, wenn der Abstand zwischen den HF-Impulsen entsprechend der Folge 2, 3, 5, 9, 17, ..., n mit n = $2^{n-1}$ + 1 variiert wird, die HF-Impulse also nur zu den Zeitpunkten 0, 1, 4, 9, 18, 35 usw. gesendet werden, wobei die Zeitpunkte ganzzahlige Vielfache des Abstandes zwischen den äquidistanten Echosignalen angeben. Allerdings läßt sich für eine solche Folge keine monotone Amplitudenänderung der Echosignale erzeugen, geschweige denn auch nur eine annähernde Gleichheit der Amplituden. Andere Möglichkeiten bestehen im Auslassen nur einzelner HF-Impulse oder auch von Gruppen von HF-Impulsen. Eine einfache Möglichkeit folgt aus der Beobachtung der Tatsache, daß die Zahl der Echosignale auch dann konstant bleibt, wenn im mittleren Drittel des Puls-Burst keine HF-Impulse vorliegen. Eine solche Operation läßt sich sukzessiv auf die verbleibenden Pakete von HF-Impulsen anwenden. Verschiedene Anwendungen dieser "Blanking"-Operation auf Teile des gesamten Puls-Burst ergibt eine sehr große Anzahl möglicher Puls-Bursts, wobei die Amplitudenmodulation der HF-Impulse für jede ihrer Folgen neu optimiert werden muß, um möglichst gleiche Amplituden der Echosignale zu erreichen. Aus der Berechnung der Signalamplitude folgt dabei, daß ein Puls-Burst aus einer lückenlosen Folge von HF-Impulsen sehr viel leichter bezüglich der Amplitudenkonstanz der Echosignale zu optimieren ist als eine Lücken aufweisende Folge von HF-Impulsen. Abschließend sei auch noch bemerkt, daß jeder beliebige Puls-Burst zeitlich invertiert werden kann, wobei allerdings die Amplituden wiederum neu berechnet werden müssen.

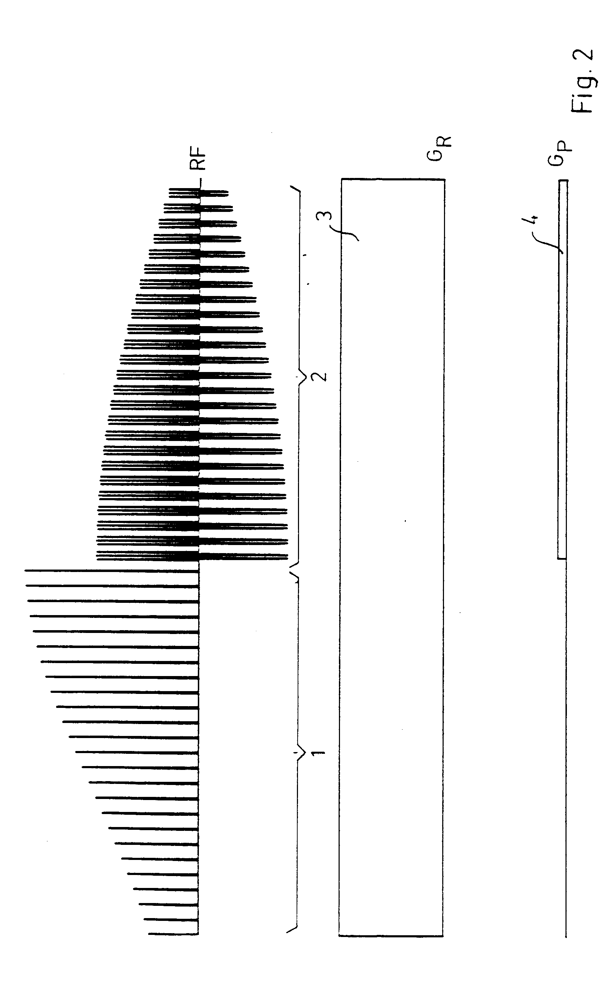

Die erfindungsgemäße Basissequenz kann in vielfältiger Weise verwendet werden. Besonders vorteilhaft ist die Verwendung bei der Bilddarstellung, weil sie zur sehr schnellen Erzeugung von Bildern führt. Dabei bildet das magnetische Gradientenfeld 3 den zur Codierung einer ersten Raumrichtung dienenden Lesegradienten $G_R$. Die Ortscodierung für die zweite Raumrichtung kann am einfachsten durch Anlegen eines zweiten Gradienten in räumlich senkrechter Richtung zum Lesegradienten $G_R$ erfolgen, wobei sich die Stärke des auch als Phasengradienten $G_P$ bezeichneten zweiten Gradienten aus dem Quotienten aus der Stärke des Lesegradienten $G_R$ mit der Zahl der ausgelesenen Echosignale ergibt. Wie in Fig. 2 dargestellt, wird der Phasengradient 4 erst nach Ende des Puls-Burst 1 angelegt und dann für die Dauer der Folge 2 der Echosignale konstant beibehalten. Dieser Phasengradient 4 bewirkt eine ständige Dephasierung der gebildeten Echosignale, so daß diese Echosignale unmittelbar durch eine zweidimensionale Fouriertransformation zu einem Bild rekonstruiert werden können.

Der zur Erzeugung der Bildsignale verwendete 2DFT-Rekonstruktionsalgorithmus beruht auf einem zeilenweisen Abtasten des Fourierraums (k-space), wobei alle Zeilen eine konstante Dephasierung besitzen. Die Datenpunkte bei dem anhand der Fig. 2 erläuterten Verfahren erhalten jedoch durch das Vorliegen eines während der Akquisition konstanten Phasengradienten eine monoton zunehmende Dephasierung, die zu Abbildungsfehlern, nämlich schräg verlaufenden Bildzeilen, führt. Allerdings sind die sich daraus ergebenden Fehler bei Verwendung einer hinreichend großen Datenmatrix unerheblich. Ab einer Datenmatrix von mindestens 32 x 32 Bildpunkten können diese Abbildungsfehler als vernachlässigbar betrachtet werden. Zwar ließe sich auch eine fehlerfreie Bildrekonstruktion durch Anpassung des Rekonstruktionsalgorithmus an die Art der Abtastung des k-Raumes erreichen, nämlich durch eine Interpolation der Daten im Zeitbereich auf ein orthogonales Raster vor der eigentlichen zweidimensionalen Fouriertransformation. Die hierzu benötigte Rechenzeit würde jedoch die Vorteile aufheben, welche sich durch die nach der Erfindung mögliche schnelle Bildaufnahme ergeben.

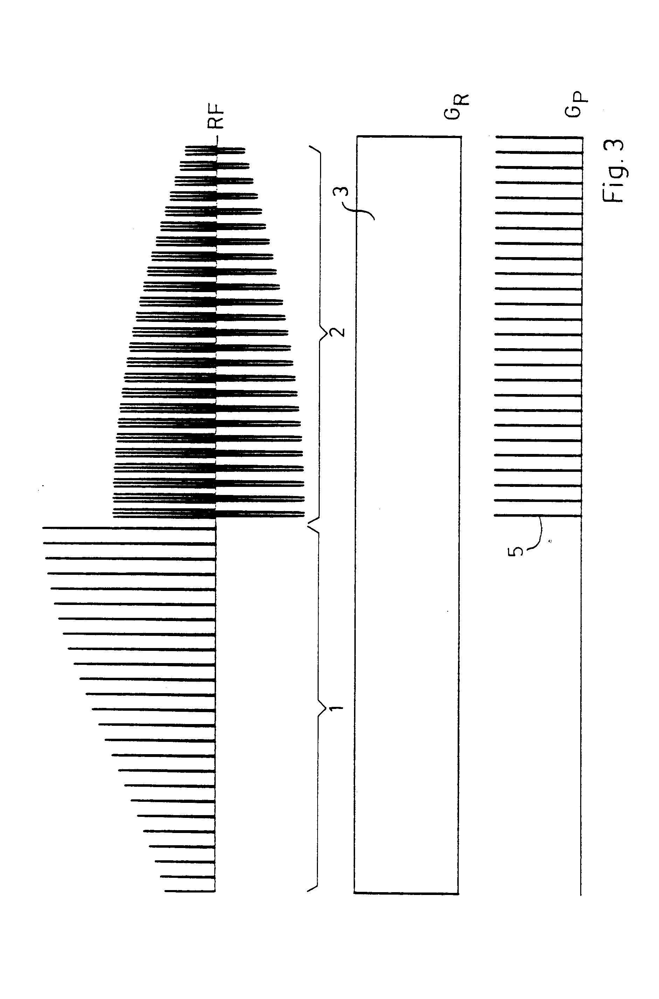

Allerdings läßt sich eine direkte Datensammlung in einem orthogonalen Raster durch die Verwendung eines nicht konstanten Phasengradienten erreichen, wie es das Diagramm nach Fig. 3 veranschaulicht. Wie ersichtlich, ist bei dem in Fig. 3 wiedergegebenen Verfahren der konstante Phasengradient 4 nach Fig. 2 durch eine Folge von sehr kurzen Phasencodier-Impulsen 5 ersetzt, die jeweils zwischen den Echosignalen 2 eingeschaltet werden. Das Einschalten der Phasencodier-Impulse ist problemlos möglich, weil diese Gradientenimpulse nur eine sehr geringe Amplitude haben.

Die anhand der Fig. 2 und 3 beschriebenen 2D-Verfahren lassen sich durch eine Ortscodierung in einer zu den Richtungen des Lesegradienten $G_R$ und des Phasengradienten $G_P$ senkrechten dritten Richtung und die Anwendung der dreidimensionalen Fouriertransformation zu einem 3D-Verfahren erweitern. Dabei sind die von den 3D-Verfahren her bekannten, verschiedenen Wege durch den dreidimensionalen k-Raum möglich.

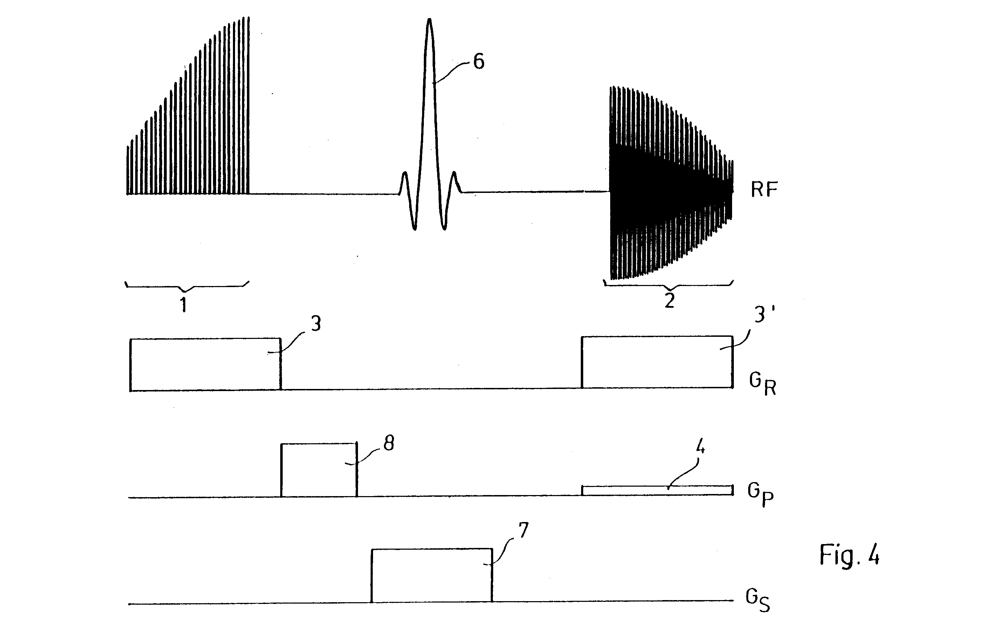

Es läßt sich aber auch das anhand der Fig. 2 und 3 beschriebene 2D-Verfahren in Verbindung mit einer in der Kernspintomographie üblichen Scheibenselektion kombinieren. So kann auch das erfindungsgemäße Verfahren in Verbindung mit einem zusätzlichen scheibenselektiven Impuls verwendet werden, der in bekannter Weise als amplituden- und gegebenenfalls auch phasenmodulierter HF-Impuls mit kleiner spektraler Bandbreite unter einem konstanten Selektionsgradienten $G_S$ eingestrahlt wird. Wie in Fig. 4 dargestellt, kann ein scheibenselektiver HF-Impuls 6 nach Abschalten des Lesegradienten 3 als Refokussierungsimpuls bei herrschendem Selektionsgradienten 7 auf die Probe eingestrahlt werden. Die refokussierte Folge 2 der Echosignale wird dann nach einer weiteren Zeit bei wieder eingeschaltetem Lesegradienten 3' empfangen. Der Phasengradient 4 kann dann wieder während des Empfangs der Echosignale 2 konstant vorliegen oder aber, wie in Fig. 3 dargestellt, getastet sein. Durch einen zusätzlichen Gradientenimpuls 8, der vor dem Refokussierimpuls 6 eingeschaltet wird, kann der Nullpunkt der Phasencodierung durch den Phasengradienten 4 in die Mitte der Folge der Echosignale 2 geschoben werden.

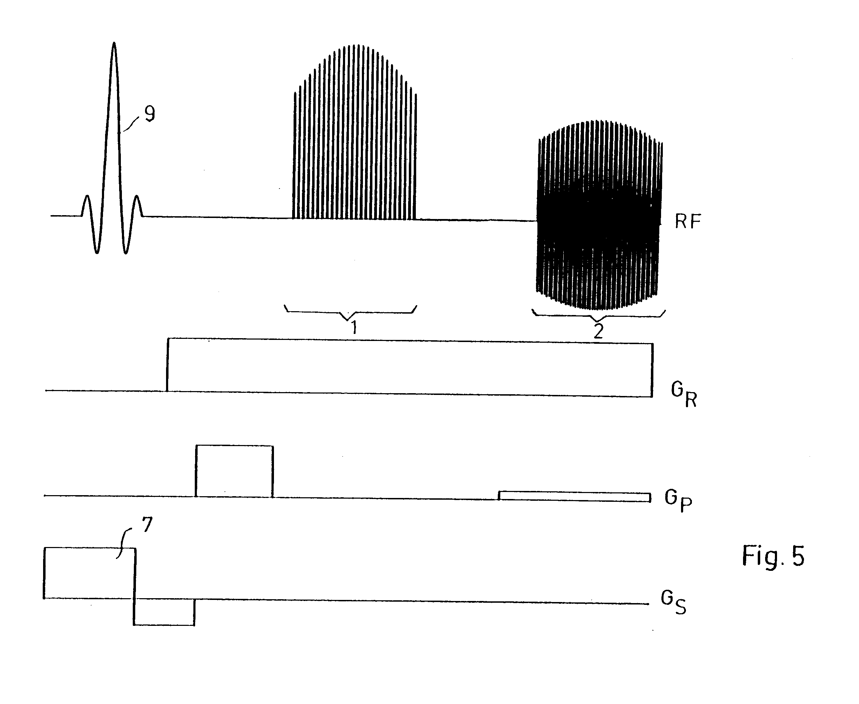

Wie aus Fig. 5 ersichtlich, kann ein zur Scheibenselektion dienender HF-Impuls 9 bei herrschendem Selektionsgradienten 7 auch vor dem Einstrahlen der Folge 1 von HF-Impulsen an die Probe angelegt werden. In diesem Fall wirkt die Folge 1 der HF-Impulse wie ein Refokussierimpuls, so daß die Folge 2 der Echoimpulse in einem zeitlichen Abstand von der Folge 1 der HF-Impulse erscheint, die dem Abstand dieser Folge 1 von dem Selektionsimpuls 9 entspricht.

Es sei auch noch erwähnt, daß eine dritte Möglichkeit der Scheibenselektion in der Unterdrückung des Signals aus den Bereichen der Probe besteht, die nicht zu der zu beobachtenden Scheibe gehören. Hierzu sind die aus der NMR-Tomographie bekannten Verfahren anwendbar, wie insbesondere die Anwendung eines Sandwich-Impulses, durch den erreicht wird, daß die selektierte Scheibe sich nach diesem Impuls im Zustand reiner z-Magnetisierung befindet, während die außerhalb der selektierten Scheibe liegenden Bereich in eine transversale Magnetisierung überführt worden sind. Daher führt die Anwendung der durch die Fig. 2 und 3 veranschaulichten Verfahren unmittelbar nach diesem Sandwich-Impuls zur Signalerzeugung ausschließlich innerhalb des in den Zustand reiner z-Magnetisierung zurückgeführten Volumens der Scheibe. Ähnlich kann auch durch die Verwendung eines volumenselektiven Sättigungspulses vor Anwendung der durch die Fig. 2 und 3 veranschaulichten Verfahren erreicht werden, daß Signale nur aus der selektierten Scheibe erhalten werden.

Um die Wirkung eines Puls-Burst zu berechnen, kann man auch von einem neuen theoretischen Ansatz ausgehen, der darin besteht, daß die Gesamtmagnetisierung eines Spinensembles nicht mehr in die elementaren Komponenten der transversalen Magnetisierungen $M_x$ und $M_y$ und der longitudinalen Magnetisierung $M_z$ zerlegt wird, sondern in komplexe Subensembles $F_n$ und $Z_n$ von Magnetisierungsvektoren, von denen $F_n$ Subensembles transversaler Magnetisierung und $Z_n$ Subensembles der z-Magnetisierung sind. Jedes Subensemble $F_n$ läßt sich als komplexe Summe von Vektoren transversaler Magnetisierung darstellen, nämlich

$$F_n = \Sigma (M_x + iM_y)$$

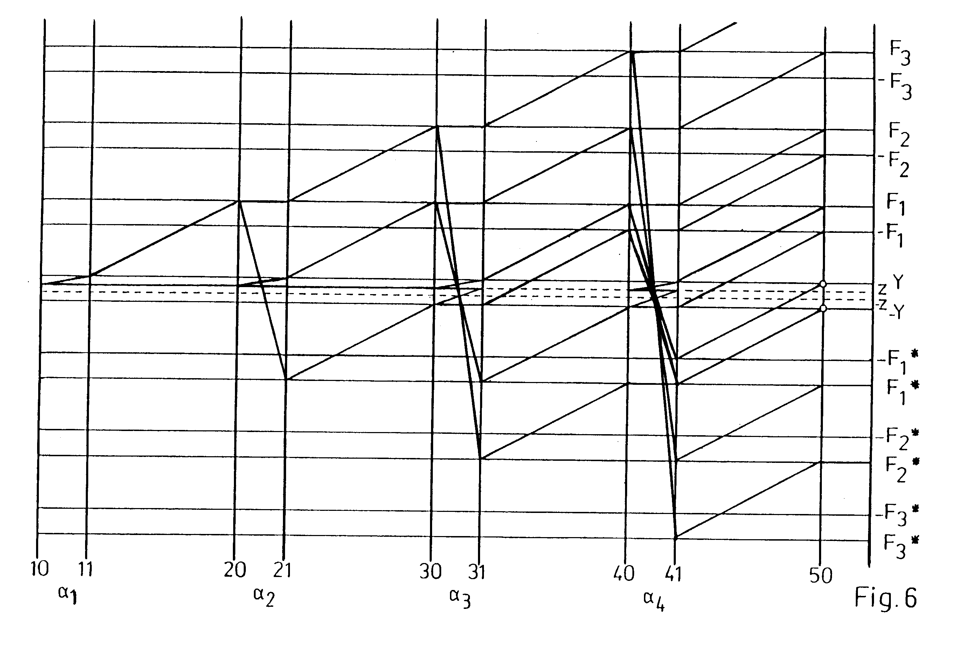

Die zeitliche Entwicklung zwischen zwei HF-Impulsen läßt sich als Transformationsgleichung zwischen solchen Subensembles darstellen. Ebenso läßt sich die Wirkung jedes HF-Impulses durch eine Transformationsgleichung zwischen solchen Subensembles beschreiben. Die Zahl der zur vollständigen Beschreibung einer Folge von HF-Impulsen erforderlichen Subensembles ergibt sich aus einem Phasendiagramm, welches alle Entwicklungsmöglichkeiten des Spinsystems berücksichtigt und in Fig. 6 dargestellt ist. Zum Zeitpunkt 10 vor dem ersten HF-Impuls, bei dem es sich um einen x-Anregungsimpuls handelt, befindet sich das Spinsystem im Zustand reiner z-Magnetisierung. Durch den x-Anregungsimpuls wird ein Teil $\sin\alpha_1$ des Spinensembles in die y-Magnetisierung übergeführt, wobei $\alpha_1$ der Flipwinkel des ersten Anregungsimpulses ist. Unter dem Einfluß des anliegenden Lesegradienten 3 (Fig. 1) dephasiert dieser Teil des Spinsystems, so daß er sich zum Zeitpunkt 20 vor dem zweiten Anregungsimpuls im Zustand $F_1$ befindet. Aufgrund der Dephasierung des Spinsystems ist die vektorielle Summe aller Spins des Subensembles $F_1$ = 0. Der nächste Anregungsimpuls invertiert einen Anteil $\sin^2(\alpha/2)$ und bringt ihn in den Zustand $F_1^*$, den

konjugiert komplexen Zustand zu $F_1$, das heißt, daß alle x-Anteile in $F_1$ erhalten bleiben und alle y-Anteile invertiert werden. Diese Anteile rephasieren unter dem Lesegradienten zu einer Magnetisierung in -y-Richtung und werden vom nächsten Anregungsimpuls mit einer $\sin\alpha_3$ entsprechenden Wahrscheinlichkeit in z-Magnetisierung übergeführt. Die von den Anregungsimpulsen nicht erfaßten Anteile der Magnetisierungen $F_n$ entwickeln sich unter dem Einfluß des Lesegradienten 3 in Zustände höher Magnetisierung. Gleichzeitig führt der Einfluß der Anregungsimpulse auf die Zustände $F_n$ zur Ausbildung sogenannter kohärenter z-Magnetisierung, welche bei darauffolgenden Anregungsimpulsen zur Ausbildung stimulierter Echos führt. Nach Beendigung der Folge von n-äquidistanten Anregungsimpulsen (HF-Impulsen) rephasieren alle Zustände $F_n^*$ und $-F_n^*$ zu -y- und y-Magnetisierungen und damit zu beobachtbaren Echos, wobei die Amplitude des n.ten Echos gleich der Menge der Spins $F_n^*$ - $(-F_n^*)$ ist, da sich die gebildeten y- und -y-Anteile kompensieren. Eine quantitative Berechnung der Amplituden aller Echosignale nach n Anregungsimpulsen läßt sich auf diese Weise durch n Matrixmultiplikationen durchführen, was auch für mehrere hundert HF-Impulse ohne weiters möglich ist.

Neben der quantitativen Berechnung läßt sich das Diagramm nach Fig. 6 auch zu relevanten qualitativen Betrachtungen verwenden. Wie bereits erwähnt, führt die gleichzeitige Bildung einer y- und einer -y-Magnetisierung aufgrund der Vektoraddition zu einer Reduktion der Amplitude der sich bildenden Echosignale. Wie aus Fig. 6 ersichtlich, ist ein solcher Zustand frühestens zum Zeitpunkt 50 erreicht und dort durch kleine Kreise angedeutet. Der Zustand y ergibt sich dabei aus der zweifachen Refokussierung der z-Magnetisierung, welche zum Zeitpunkt 10 angeregt wurde, via zy - $F_1F^{1*}$ - -y-y - $-F_1-F_1^*$ - y, während sich der Zustand -y durch einfache Refokussierung der durch den dritten HF-Impuls angeregten Magnetisierung (aber auch anderer Anteile) ergibt. Dies bedeutet, daß die Amplitude aller derjenigen Echosignale reduziert wird, die auf einem Weg mit mehr als einer Refokussierung zustande kommen. Große Flipwinkel erhöhen die Refokussierungswahrscheinlichkeit entsprechend $\sin^2(\alpha/2)$. Dies führt dazu, daß bei Verwendung von großen Flipwinkeln bereits nach wenigen Echos solche gegenphasigen Signale erzeugt werden und die Amplitude der Echosignale schnell abfällt. Bei kleinen Flipwinkeln wird dagegen das Gesamtsignal von Magnetisierungen bestimmt, welche nur eine Refokussierung erlitten haben. Dementsprechend erfolgt der Abfall der Amplitude der Echosignale langsamer.

Für kleine Flipwinkel ist $\sin\alpha \approx \alpha$ und $\sin^2(\alpha/2) \approx \alpha^2/4$. Die Intensität der Echosignale wird dann von der Zahl der möglichen Wege mit einer Refokussierung zur Echobildung bestimmt. Das erste Echo nach Beendigung des Puls-Burst wird als Summe aus der Refokussierung des (n-1).ten HF-Impulses am n.ten HF-Impuls und des (n-3).ten HF-Impulses am (n-1).ten HF-Impulses usw. gebildet. Der Zerfall der Amplituden der Echosignale läßt sich dann aus der Anzahl der möglichen Refokussierungswege berechnen. Für HF-Impulse mit unterschiedlichem $\alpha_n$ läßt sich umgekehrt solch ein Gleichungssystem aufstellen, dessen Lösung einen Satz von Flipwinkeln $\alpha_n$ ergibt, welche zu einem möglichst gleichmäßigen Abfall der Amplitude der Echosignale führen.

Der hier diskutierte Formalismus ist auch leicht für HF-Impulse erweiterbar, welche in Bezug auf ihre Phase moduliert sind. Das Phasendiagramm muß dann um die um 90° phasenverschobenen Zustände $iF_n$, $-iF_n$, $iF_n^*$ und $-iF_n^*$ erweitert werden. Durch eine Phasenmodulation der Flipwinkel kann dann der Anteil der gegenphasigen Magnetisierungen, der zur Reduktion der Amplituden der Echosignale führt, vermindert werden, so daß die Amplituden der Echosignale langsamer abfallen. So führt zum Beispiel eine Modifikation des Puls-Burst, bei der die erste Hälfte der HF-Impulse gegenüber der zweiten Hälfte um 90° phasenverschoben ist, zu einer Verlängerung des Echozuges.

Etwas anders ausgedrückt, läßt sich nach der gängigen Theorie die Gesamtmagnetisierung durch einen Vektor B wiedergeben, welcher die Verteilung der Magnetisierungen auf die Komponeneten $M_x$ , $M_y$ und $M_z$ wiederspiegelt. Im thermischen Gleichgewicht ist dieser gegeben durch

$$B \;=\; \begin{pmatrix} 0 \\ 0 \\ 1 \end{pmatrix}$$

sofern man den Koeffizienten der Gleichgewichtsmagnetisierung auf 1 normiert. Die Beschreibung der zeitlichen Entwicklung der Magnetisierung unter einem Puls-Burst verlangt, wie ausgeführt, eine Unterteilung von B in eine größere Anzahl von Koeffizienten, welche die Besetzung der relevanten Zustände $F_1$ , $F_1^*$ , $Z_1$ , $Z_1^*$ wiedergeben, wobei die Zustände $Z_n$ die den Zuständen $F_n$ entsprechenden Ensembles kohärenter z-Magnetisierung repräsentieren, welche zur Ausbildung der sog. stimulierten Echos führen, wie

7

es in Fig. 6 dargestellt ist. B enthält demnach die Koeffizienten der Ensembles
$M_x\ M_y\ M_z\ F_1\ -F_1\ F_1{}^*\ -F_1{}^*\ ...$
Die Wirkung eines jeden HF-Impulses mit dem Flipwinkel $\alpha_n$ läßt sich durch eine Matrixmultiplikation beschreiben:

$$
B'_n\ -\ B_n
\begin{bmatrix}
T_0 & & & & \\
 & T_1 & & & \\
 & & T_1 & & \\
 & & & T_1 & \\
 & & & & T_1
\end{bmatrix}
$$

$B'_n$ beschreibt die Magnetisierung nach dem Puls $B_n$ die Magnetisierung vor dem HF-Impuls.
$T_0$ ist die Rotationsmatrix für einen HF-Impuls der Phase x.

$$
T_0\ =\
\begin{bmatrix}
1 & 0 & 0 \\
0 & \cos \alpha_n & -\sin \alpha_n \\
0 & \sin \alpha_n & \cos \alpha_n
\end{bmatrix}
$$

$T_1$ ist die Transfomationsmatrix welche den Übergang der dephasierten Zustände $F_n$ ... beschreibt. Die Koeffizienten sind wie folgt definiert:
$\cos^2(\alpha_n/2)$ : für alle Übergänge von $F_n$, $F_n{}^*$, $F_n$ und $-F_n{}^*$ in sich selbst.
$\sin^2(\alpha_n/2)$ : für die Übergänge $F_n$ nach $-F_n{}^*$, $-F_n$ nach $F_n{}^*$, $F_n{}^*$ nach $-F_n$ und $-F_n{}^*$ nach $F_n$.
$\sin \alpha_n$ : Für die Erzeugung der transversalen Ensembles $F_n$, $-F_n$, $F_n{}^*$ und $-F_n{}^*$ aus den longitudinalen Zuständen.
$1/2 \sin \alpha_n$ : Für die Erzeugung der longitudinalen Ensembles $Z_n$ und $-Z_n$ aus jedem $F_n$, entsprechend für alle anderen Zustände $-F_n$, $F_n{}^*$ und $-F_n{}^*$.
$\cos \alpha_n$ : Für die Erhaltung jeden Zustandes $Z_n$, $-Z_n$, $Z_n{}^*$ und $-Z_n{}^*$.
Die Übergänge zwischen den Pulsen können dem Diagramm nach Fig. 6 entnommen werden. Repetitive Anwendung dieses Formalismus führt zu den Koeffizienten $\pm F_n{}^*$ nach Beendigung des Pulspakets, welche durch sukzessive Refokussionierung durch den stehenden Gradienten b die Amplituden der nachfolgenden Echos $E_n$ ergeben. Für phasenmodulierte Pulse läßt sich dieser Formalismus durch Hinzunahme der entsprechenden Zustände leicht erweitern.

Die vorstehenden Ausführungen haben deutlich gemacht, daß das erfindungsgemäße Verfahren in vielfältiger Weise variiert werden kann, insbesondere durch die Beschaffenheit des Puls-Burst, dessen HF-Impulse in unterschiedlicher Weise variierte Amplituden und Phasen des Trägersignals aufweisen können und dessen grundsätzlich äquidistante Folge von HF-Impulsen auch Lücken aufweisen kann. Ebenso ergeben sich für das erfindungsgemäße Verfahren überall dort Anwendungsmöglichkeiten, wo die Anwendung von Folgen von Echoimpulsen nützlich ist, die eine durch ein Gradientenfeld aufgeprägte Codierung aufweisen. Ein besonders bevorzugtes Anwendungsgebiet ist die Bilderzeugung, bei der das erfindungsgemäße Verfahren mit allen aus der NMR-Tomographie bekannten Verfahren kombiniert werden kann.

Das erfindungsgemäße Verfahren läßt sich mit allen herkömmlichen NMR-Spektrometern ausführen sowie auch bei Kernspin-Tomographen verwenden, sofern der Sender dieser Geräte dazu eingerichtet ist, eine schnelle Folge von HF-Signalen mit vorgegebener Amplitudenvariation und gegebenenfalls auch vorgegebener Variation dar Phase des HF-Trägersignals zu erzeugen. Die hierfür gegebenenfalls erforderlichen Modifikationen herkömmlicher Geräte kann der einschlägige Fachmann ohne weiteres vornehmen.

Nachstehend wird ein Beispiel für die Erzeugung eines Bildes nach dem erfindungsgemäßen Verfahren angegeben. Es wurde ein aus 128 HF-Impulsen bestehender Puls-Burst verwendet, dessen HF-Impulse entsprechend einem Magnetfeld der Stärke 4,7 Tesla eine Trägerfrequenz von 200 MHz, eine Länge von 2

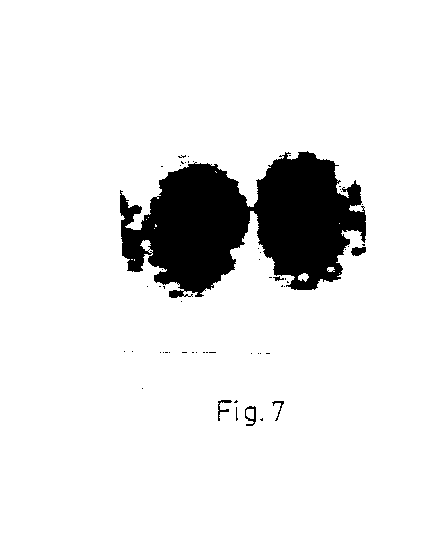

μs und einen Abstand von 120 μs hatten und deren Flipwinkel gaussförmig von 0,5° bis 2° zunahm. Die erste Hälfte der HF-Impulse hatte eine gegenüber der zweiten Hälfte um 90° verschobene Phase. Unter einem Lesegradienten von ca. 80 mT/m und einem Phasengradienten von ca. 80/128 mT/m wurden 128 Echosignale erhalten und bei einer Aufnahmebandbreite von 1 MHz in insgesamt 32 K Daten erfaßt, die dann durch eine zweidimensionale Fouriertransformation zu dem in Fig. 7 dargestellten, aus 128x128 Punkten aufgebauten Bild verarbeitet wurden. Die Aufnahmezeit betrug 8 ms.

**Patentansprüche**

1.  Verfahren zur Erzeugung einer Folge von Spinechosignalen (2) bei der NMR-Spehtroskopie, bei dem eine in einem homogenen Magnetfeld angeordnete Probe mit einer Folge von HF-Impulsen (1) angeregt wird, die die Erzeugung von Spinechosignalen (2) zur Folge haben, wobei die Probe gleichzeitig einem magnetischen Gradientenfeld (3) ausgesetzt und zur Anregung der Probe eine Folge von äquidistanten HF-Impulsen (1) mit Flipwinkeln $\alpha < 180°$ verwendet wird,
    dadurch gekennzeichnet, daß die HF-Impulse (1) unterschiedliche Amplituden aufweisen und die Flipwinkel $\alpha$ und die Amplituden der HF-Impulse derart gewählt sind, daß das Produkt aus der Anzahl der HF-Impulse (1) und dem Flipwinkel der einzelnen Impulse einen Gesamt-Flipwinkel zwischen 90° und 180° ergibt und im Anschluß an die Folge der HF-Impulse (1) ein Zug von äquidistanten Echosignalen (2) mit möglichst konstanter Amplitude erhalten wird.

2.  Verfahren nach Anspruch 1, dadurch gekennzeichnet, daß die Größe des magnetischen Gradientenfeldes (3, 3', 4, 5, 7, 8) in dem Zeitintervall zwischen der Folge der HF-Impulse (1) und dem Beginn der Folge der Echosignale (2) geändert wird.

3.  Verfahren nach Anspruch 1 oder 2, dadurch gekennzeichnet, daß eine Folge äquidistanter HF-Impulse (1) erzeugt wird, die an vorgegebenen Stellen Lücken aufweist.

4.  Verfahren nach einem der vorhergehenden Ansprüche, dadurch gekennzeichnet, daß die HF-Impulse (1) zusätzlich phasenmoduliert werden.

5.  Verfahren nach Anspruch 4, dadurch gekennzeichnet, daß die Phase einer Hälfte der HF-Impulse (1) gegenüber der Phase der zweiten Hälfte der HF-Impulse (1) um 90° phasenverschoben sind.

6.  Verwendung des Verfahrens nach einem der vorhergehenden Ansprüche zur Erzeugung der für die Punkte eines zweidimensionalen Bildes charakteristischen Signale bei der Kernspintomographie,
    dadurch gekennzeichnet, daß
    nach Abschluß der Folge von HF-Impulsen (1) und für die Dauer der Folge der Echosignale (2) die Probe zusätzlich einem zum magnetischen Gradientenfeld (3, 3') senkrechten magnetischen Phasengradienten (4, 5) ausgesetzt wird und die erhaltenen Echosignale (2) einer zweidimensionalen Fouriertransformation unterworfen werden, welche die für die Punkte des Bildes charakteristischen Signale ergibt.

7.  Verwendung nach Anspruch 6, dadurch gekennzeichnet, daß der Phasengradient (4) während der Dauer der Folge der Echosignale (2) konstant ist.

8.  Verwendung nach Anspruch 6, dadurch gekennzeichnet, daß der Phasengradient (5) jeweils in den Intervallen zwischen den einzelnen Echosignalen (2) impulsartig eingeschaltet wird.

9.  Verwendung nach einem der Ansprüche 6 bis 8, dadurch gekennzeichnet, daß die Erzeugung der für die Punkte eines zweidimensionalen Bildes charakteristischen Signale mit Maßnahmen zur Scheibenselektion kombiniert werden.

10. Verwendung nach Anspruch 9, dadurch gekennzeichnet, daß vor dem Einstrahlen der Folge der HF-Impulse (1) die Probe einem Scheibenselektionsgradienten (7) und einem selektiven Anregungsimpuls (9)ausgesetzt wird, nach dem dann die Folge der HF-Impulse (1) die Wirkung eines Refokussierimpulses hat.

**11.** Verwendung nach Anspruch 9, dadurch gekennzeichnet, daß vor dem Einstrahlen der Folge der HF-Impulse (1) die Probe einem Scheibenselektionsgradienten (7) und einem HF-Impuls ausgesetzt wird, durch den die außerhalb der selektierten Scheibe liegenden Bereiche der Probe gesättigt werden.

**12.** Verwendung nach Anspruch 9, dadurch gekennzeichnet, daß nach Beendigung der Folge von HF-Impulsen (1) und vor Beginn der Folge von Echoimpulsen (2) auf die Probe ein scheibenselektiver Refokussierimpuls (6) eingestrahlt und für die Dauer des Refokussierimpulses (6) das magnetische Gradientenfeld (3, 3') durch einen Selektionsgradienten (7) ersetzt wird.

**13.** Verwendung des Verfahrens nach einem der Ansprüche 1 bis 5 zur Erzeugung der für die Punkte eines dreidimensionalen Bildes charakteristischen Signale bei der Kernspintomographie,
dadurch gekennzeichnet, daß
ein Verfahren nach einem der Ansprüche 4 bis 10 durch Maßnahmen zur Erfassung der zur Scheibenebene senkrechten, dritten Dimension der Probe ergänzt wird.

**14.** Vorrichtung zum Durchführen des Verfahrens nach einem der Ansprüche 1 bis 5 und ggf. seiner Verwendung nach einem der Ansprüche 6 bis 13, mit einem zur Erzeugung von HF-Impulsen (1) ausgebildeten Sender,
dadurch gekannzeichnet, daß
der Sender zur Erzeugung von Folgen äquidistanter HF-Impulse (1) mit von Impuls zu Impuls veränderlicher Amplitude und ggf. Phase eingerichtet ist, und daß Steuereinrichtungen vorgesehen sind, mittels derer die Flipwinkel $\alpha$ und die Amplituden der HF-Impulse (1) so gesteuert werden können, daß das Produkt aus der Anzahl der HF-Impulse (1) und dem Flipwinkel der einzelnen Impulse einen Gesamt-Flipwinkel zwischen 90° und 180° ergibt und im Anschluß an die Folge der HF-Impulse (1) ein Zug von äquidistanten Echosignalen (2) mit möglichst konstanter Amplitude erhalten wird.

**Claims**

**1.** A method for generating a sequence of spin echo signals (2) in NMR spectroscopy, in which a sample placed in a homogeneous magnetic field is excited by a sequence of rf pulses (1) resulting in the generation of spin echo signals (2) wherein the sample is simultaneously exposed to a magnetic gradient field (3) and wherein for exciting the sample a sequence of equidistant rf pulses (1) with flip angles $\alpha < 180°$ are used, characterized in that the rf pulses (1) have different amplitudes and the flip angles $\alpha$ and amplitudes of the rf pulses are selected in such a manner that the product of the number of rf pulses (1) and the flip angle by the individual pulses leads to an overall flip angle of between 90° and 180° and that, following the sequence of rf pulses (1), a train of equidistant echo signals (2) of an amplitude as constant as possible is obtained.

**2.** A method according to claim 1, wherein the magnitude of the magnetic gradient field (3, 3', 4, 5, 7, 8) is varied during the time interval between the sequence of rf pulses (1) and the beginning of the sequence of echo signals (2).

**3.** A method according to claim 1 or 2, wherein a sequence of equidistant rf pulses (1) is generated which is interrupted by gaps at predetermined points.

**4.** A method according to any of the preceding claims, wherein the rf pulses (1) are phase-modulated in addition.

**5.** A method according to claim 4, wherein the phase of one half of the rf pulses (1) is phase-shifted by 90° relative to the phase of the other half of the rf pulses.

**6.** Application of the method according to any of the preceding claims for the generation of the signals characteristic of the points of a two-dimensional image in nuclear spin tomography, characterized in that the sample is exposed additionally, after termination of the sequence of rf pulses (1) and for the duration of the sequence of the echo signals (2), to a magnetic phase gradient (4, 5) directed perpendicular to the magnetic gradient field (3, 3'), and the echo signals (3) so obtained are subjected to two-dimensional Fourier transformation which then provides the signals characteristic of the points of the image.

**7.** Application according to claim 6, wherein the phase gradient (4) is constant during the sequence of the echo signals (2).

**8.** Application according to claim 6, wherein the phase gradient (5) is switched on in a pulse-like manner in the intervals between the individual echo signals (2).

**9.** Application according to any of claims 6 to 8, wherein the generation of the signals characteristic of the points of a two-dimensional image are combined with slice-selective measures.

**10.** Application according to claim 9, wherein the sample is subjected, before irradiation of the sequence of rf pulses (1), to a slice-selection gradient (7) and a selective excitation pulse (9), whereafter the sequence of the rf pulses (1) will have the effect of a refocussing pulse.

**11.** Application according to claim 9, wherein the sample is subjected, prior to irradiation of the sequence of the rf pulses (1), to a slice-selection gradient (7) and an rf pulse, which saturates the area of the sample positioned outside the selected slice.

**12.** Application according to claim 9, wherein a slice-selective refocussing pulse (6) is irradiated upon the sample after termination of the sequence of rf pulses (1) and before the beginning of the sequence of echo pulses (2), and the magnetic gradient field (3, 3') is replaced by selection gradient (7) for the duration of the refocussing pulse (6).

**13.** Application according to any of claims 1 to 5 for the generation of the signals characteristic of the points of a two-dimensional image in nuclear spin tomography, wherein a method according to any of claims 4 to 10 is supplemented by measures for recording the third dimension of the sample, i.e. the dimension perpendicular to the slice plane.

**14.** A device for carrying out the method according to any of claims 1 to 5 and, if applicable, also according to its application according to any of claims 6 to 13, comprising a transmitter capable of generating rf pulses (1), wherein the transmitter is adapted for generating sequences of equidistant rf pulses (1) with amplitudes and, under certain circumstances, phases varying from pulse to pulse, and wherein control means are provided for, by operation of which the flip angles a and the amplitudes of the rf pulses (1) can be controlled such that the product of the number of rf pulses (1) and the flip angle of each individual pulse leads to an overall flip angle of between 90° and 180° and that, following the sequence of rf pulses (1), a train of equidistant echo signals (2) of an amplitude as constant as possible is obtained.

**Revendications**

**1.** Procédé de génération d'une séquence de signaux d'écho de spin (2) en spectroscopie RMN, dans lequel un spécimen disposé dans un champ magnétique homogène est excité par une séquence d'impulsions HF (1) qui ont pour conséquence la production d'échos de spin (2), le spécimen étant en même temps exposé à un champ à gradient magnétique (3), et une séquence d'impulsions HF équidistantes (1) avec angles de basculement $\alpha < 180°$ est utilisée pour exciter le spécimen, caractérisé par le fait que les impulsions HF (1) présentent des amplitudes différentes, et les angles de basculement $\alpha$ ainsi que les amplitudes des impulsions HF sont choisis de manière telle que le produit du nombre des impulsions HF (1) et de l'angle de basculement des impulsions individuelles donne un angle de basculement global entre 90° et 180° et que l'on obtienne à la suite de la séquence d'impulsions HF (1) un train de signaux d'écho équidistants (2) ayant une amplitude aussi constante que possible (2).

**2.** Procédé selon revendication 1, caractérisé par le fait que la grandeur du champ à gradient magnétique (3, 3', 4, 5, 7, 8) est modifiée dans l'intervalle de temps entre la séquence des impulsions HF (1) et le début de la séquence des signaux d'écho (2).

**3.** Procédé selon revendication 1 ou 2, caractérisé par le fait que l'on produit une séquence d'impulsions HF équidistantes (1) qui présente des créneaux en des endroits prédéterminés.

**4.** Procédé selon l'une des revendications précédentes, caractérisé par le fait que les impulsions HF (1) sont en outre modulées en phase.

**5.** Procédé selon revendication 4, caractérisé par le fait que la phase d'une moitié des impulsions HF (1) est décalée de 90° par rapport à la phase de l'autre moitié des impulsions HF (1).

**6.** Utilisation du procédé selon l'une des revendications précédentes pour la production de signaux caractéristiques pour les points d'une image bidimensionnelle en tomographie par spin nucléaire, caractérisée

par le fait qu'après la fin de la séquence d'impulsions HF (1), et pour la durée de la suite des signaux d'écho (2), on expose en outre le spécimen à un gradient de phase magnétique (4, 5) perpendiculaire au champ à gradient magnétique (3, 3'), et l'on soumet les signaux d'écho (2) obtenus à une transformation de Fourier bidimensionnelle qui donne les signaux caractéristiques pour les points de l'image.

**7.** Utilisation selon revendication 6, caractérisée par le fait que le gradient de phase (4) est constant pendant la durée de la séquence des signaux d'écho (2).

**8.** Utilisation selon revendication 6, caractérisée par le fait que le gradient de phase (5) est appliqué à chaque fois, en mode impulsionnel, dans les intervalles entre les signaux d'écho individuels (2).

**9.** Utilisation selon l'une des revendications 6 à 8, caractérisée par le fait que la production des signaux caractéristiques pour les points d'une image bidimensionnelle est combinée avec des dispositions de sélection de tranche.

**10.** Utilisation selon revendication 9, caractérisée par le fait qu'avant l'irradiation par la séquence d'impulsions HF (1), on expose le spécimen à un gradient (7) de sélection de tranche et à une impulsion d'excitation (9), après quoi la séquence des impulsions HF (1) a alors l'effet d'une impulsion refocalisante.

**11.** Utilisation selon revendication 9, caractérisée par le fait qu'avant l'irradiation par la séquence d'impulsions HF (1), expose le spécimen à un gradient (7) de sélection de tranche et à une impulsion HF par laquelle les régions du spécimen situées en dehors de la tranche sélectionnée sont saturées.

**12.** Utilisation selon la revendication 9, caractérisée par le fait qu'après la fin de la séquence d'impulsions HF (1), et avant le début de la séquence d'impulsions d'écho (2) on irradie le spécimen avec une impulsion refocalisante (6), sélective quant à la tranche, et, pendant la durée de l'impulsion refocalisante (6), on remplace le champ à gradient magnétique (3, 3') par un gradient de sélection (7).

**13.** Utilisation du procédé selon l'une des revendications 1 à 5 pour produire des signaux caractéristiques pour les points d'une image tridimensionnelle, en tomographie par spin nucléaire, caractérisée
par le fait que l'on complète un procédé selon l'une des revendications 4 à 10 par des dispositions pour la lecture ou saisie de la troisième dimension, perpendiculaire au plan de la tranche.

**14.** Dispositif de mise en oeuvre du procédé selon l'une des revendication 1 à 5 et éventuellement pour son utilisation selon l'une des revendications 6 à 13, comportant un émetteur pour la production d'impulsions HF (1),
caractérisé
par le fait que l'émetteur est agence pour la production de séquences d'impulsions HF équidistantes (1) avec amplitude et éventuellement phase variable(s) d'impulsion en impulsion, et par le fait qu'il est prévu des dispositifs de commande au moyen desquels les angles de basculement a et les amplitudes des impulsions HF (1) peuvent être commandées de manière telle que le produit du nombre des impulsions HF (1) et de l'angle de basculement des impulsions individuelles donne un angle de basculement global entre 90° et 180°, et que l'on obtienne, à la suite de la séquence des impulsions HF (1), un train de signaux d'écho équidistants (2) dont l'amplitude est aussi constante que possible.

Fig.1

Fig. 2

Fig. 3

RF

1

2

3

3'

$G_R$

6

8

4

$G_P$

7

$G_S$

Fig. 4

Fig. 5

Fig. 6

EP 0 378 628 B1

Fig. 7